# EUROPEAN PATENT APPLICATION

(11) **EP 3 240 177 A1**
(43) Date of publication of application: **01.11.2017**
(21) Application number: 14900339.4
(22) Date of filing: 22.12.2014
(51) Int. Cl.: H02M 7/48, H02M 7/12, H03K 17/12, H02M 1/08

(54) **SWITCHING DEVICE, MOTOR DRIVE DEVICE, POWER CONVERSION DEVICE, AND SWITCHING METHOD**

(71) Applicant: Mitsubishi Electric Corporation, Chiyoda-ku Tokyo 100-8310 (JP)
(72) Inventor: SUZUKI, Daisuke, Tokyo 100-8310 (JP)
(74) Representative: Pfenning, Meinig & Partner mbB
(86) International application number: PCT/JP2014/083942
(87) International publication number: WO 2016/103328

(57) **Abstract**

To provide a switching device 1 including a switching circuit unit 11 constituted by connecting in parallel an IGBT 11a and a MOSFET 11b having a faster switching speed than a switching speed of the IGBT 11a, and a control unit 12 that turns on the IGBT 11a after the MOSFET 11b is turned on, at a time of executing on-control, and turns off the MOSFET 11b after turning off the IGBT 11a, at a time of executing off-control. Accordingly, a load can be driven efficiently in an operation range from a low load range to a high load range.

## Description

### Field

The present invention relates to a switching device that controls a switching circuit unit, a motor drive device, a power conversion device, and a switching method.

### Background

In a power conversion device, a switching loss at the time of switching is reduced by using a switching element having high switching speed such as a MOSFET (Metal-Oxide-Semiconductor Field-Effect Transistor).

Furthermore, a device in which a switching element having high switching speed and a switching element having low switching speed but with a low steady loss are connected in parallel, and these switching elements are switched based on the magnitude of a load, has been proposed (Patent Literature 1 listed below). In Patent Literature 1, a MOSFET is exemplified as the switching element having high switching speed, and an IGBT (Insulated Gate Bipolar Transistor) is exemplified as the switching element having a low switching speed but with a low steady loss.

In Patent Literature 1, it is described that "the loss is reduced by an FET as in the past when the current is smaller than the current I1, and when the current is larger than the current I1, an increase in the loss of the FET is reduced by imposing more burden on the IGBT".

### Citation List

### Patent Literature

Patent Literature 1: Japanese Patent Application Laid-open No. H10-80152

### Summary

### Technical Problem

In the IGBT used in the power conversion device, if a collector-emitter saturation voltage is large, a loss due to the collector-emitter saturation voltage in a steady state increases. Therefore, a switching element having a low collector-emitter saturation voltage is required in order to reduce the loss in the steady state. In the following descriptions, the collector-emitter saturation voltage is referred to as "VCEsat".

In recent years, a switching element having high switching speed with a low VCEsat has been developed. However, in order to cope with a large current, the switching element needs to have a large size, and accordingly increasing the price thereof increases.

Conventionally, there has been a low-cost switching element having a low VCEsat and is capable of passing a large current. However, in the case of a switching element having a high voltage resistance, if the VCEsat is low, the switching speed becomes slow, and the switching loss at the time of turning on or turning off is made large.

In Patent Literature 1 described above, because a MOSFET having fast switching speed is used in a region where an operation load is small and a switching frequency is high, the switching loss in the switching can be reduced, but the steady loss in a steady state increases. On the other hand, in a region where the operation load is large and a switching frequency is low, an IGBT having slow switching speed is used. Therefore, although the steady loss in the steady state can be reduced, there is a problem in that the switching loss increases at the time of switching, and thus the load cannot be driven efficiently in all regions from a region where the operation load is small to a region where the operation load is large.

The present invention has been achieved in view of the above problems, and an object of the present invention is to provide a switching device, a motor drive device, a power conversion device, and a switching method that can drive a load efficiently in all regions from a region where an operation load is small to a region where an operation load is large.

### Solution to Problem

In order to solve the aforementioned problems, a switching device according to one aspect of the present invention is so constructed as to include: a switching circuit unit constituted by connecting in parallel a first switching element and a second switching element having a faster switching speed than a switching speed of the first switching element; and a control unit that turns on the first switching element after turning on the second switching element, at a time of executing on-control, and turns off the second switching element after turning off the first switching element, at a time of executing off-control.

### Advantageous Effects of Invention

According to the present invention, it is made possible to drive a load efficiently in all regions from a region where an operation load is small to a region where an operation load is large.

### Brief Description of Drawings

FIG. 1 is a configuration diagram of a switching device according to a first embodiment.
FIG. 2 is an explanatory diagram of a change of a current due to switching control of a switching device according to the first embodiment.
FIG. 3 is a configuration diagram of a motor drive device according to a second embodiment.
FIG. 4 is a configuration diagram of a power conversion device according to a third embodiment.

### Description of Embodiments

Exemplary embodiments of a switching device, a motor drive device, a power conversion device, and a switching method according to the present invention will be explained below in detail with reference to the accompanying drawings. The present invention is not limited to the embodiments.

### First embodiment.

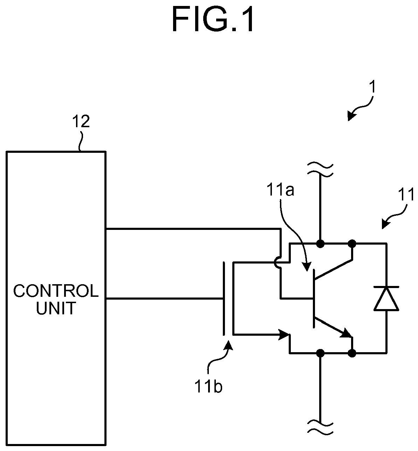

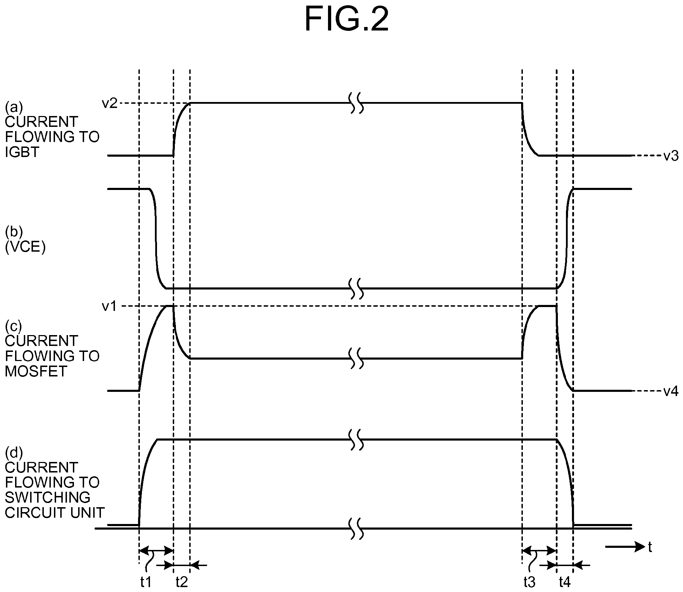

FIG. 1 is a configuration diagram of a switching device 1 according to a first embodiment. FIG. 2 is an explanatory diagram of a change of current due to switching control of the switching device 1 according to the first embodiment.

The switching device 1 includes a switching circuit unit 11 constituted by switching elements, and a control unit 12 that controls the switching elements.

The switching circuit unit 11 is constituted by connecting in parallel an IGBT (Insulated Gate Bipolar Transistor) 11a as a first switching element that performs switching and a MOSFET (Metal Oxide-Semiconductor Field-Effect Transistor) 11b as a second switching element that performs switching. The MOSFET 11b is a switching element having a higher switching speed than that of the IGBT 11a.

When performing a power-on control, the control unit 12 turns on the IGBT 11a after turning on the MOSFET 11b, and when performing a power-off control, the control unit 12 turns off the MOSFET 11b after turning off the IGBT 11a. Here, "turn-on" means transition of the switching element from an off-state to an on-state, and "turn-off" means transition of the switching element from the on-state to the off-state.

The IGBT 11a has a lower VCEsat than that of the MOSFET 11b. The MOSFET 11b has a smaller switching loss than that of the IGBT 11a.

A specific operation of the switching device 1 is explained with reference to FIG. 2. (a) in FIG. 2 indicates a change of current flowing to the IGBT 11a due to the turn-on and turn-off. (b) in FIG. 2 indicates a change of VCE in the switching circuit unit 11 due to the turn-on and turn-off. (c) in FIG. 2 indicates a change of current flowing to the MOSFET 11b due to the turn-on and turn-off. (d) in FIG. 2 indicates a change of current flowing to the switching circuit unit 11 due to the turn-on and turn-off.

Further, a time t1 in FIG. 2 indicates a time after the current flowing to the MOSFET 11b has increased up to a set value v1 according to the turn-on by the control unit 12 until a preset time elapses. A time t2 in FIG. 2 indicates a time until the current flowing to the IGBT 11a increases up to a set value v2 according to the turn-on by the control unit 12. The time required for performing the turn-on of the switching circuit unit 11 is a total time of the time t1 and the time t2.

A time t3 in FIG. 2 indicates a time after the current flowing to the IGBT 11a has decreased to a set value v3 according to the off-control by the control unit 12 until a preset time elapses. A time t4 in FIG. 2 indicates a time until the current flowing to the MOSFET 11b decreases to a set value v4 according to the off-control by the control unit 12. The time required for performing the turn-off of the switching circuit unit 11 is a total time of the time t3 and the time t4.

The on-control is explained first. The control unit 12 turns on the MOSFET 11b. The control unit 12 turns on the IGBT 11a at the timing at which the time t1 has elapses since the turn-on of the MOSFET 11b and a steady current starts to flow to the MOSFET 11b.

As described above, in the switching device 1, when the IGBT 11a is turned on, the current is flowing to the MOSFET 11b that has been turned on first. Therefore, the current has been already flowing in the entire switching circuit 11.

Furthermore, in the switching device 1, during a period from the at which the IGBT 11a starts to be turned on until it comes to a steady state, because resistance components in the IGBT 11a are large, most of the current flows to the MOSFET 11b.

In the switching device 1, when the IGBT 11a comes to the steady state, because the VCEsat of the IGBT 11a is low, the current same as the current flowing to the MOSFET 11b flows to the IGBT 11a. In the switching device 1, as illustrated in (a) and (c) of FIG. 2, when the IGBT 11a comes to the steady state, while the steady current also flows to the IGBT 11a, the steady current that has been flowing to the MOSFET 11b decreases.

A case of executing off-control is explained next. The control unit 12 turns off the IGBT 11a. Due to the turn-off, the resistance components of the IGBT 11a increase. However, the MOSFET 11b has low resistance components because it is in the steady state. Therefore, most of the current flows to the MOSFET 11b, as illustrated in FIG. 2(c).

The control unit 12 turns off the MOSFET 11b after turn-off of the IGBT 11a.

Accordingly, at the time of executing the on-control, the switching device 1 first turns on the MOSFET 11b having a smaller switching loss than that of the IGBT 11a. Consequently, the switching loss can be reduced.

Furthermore, because the switching device 1 can decrease the current flowing to the IGBT 11a, which is turned on after the MOSFET 11b, the switching loss due to the IGBT 11a can be also reduced.

Further, in the switching device 1, because the VCEsat of the IGBT 11a and the MOSFET 11b is low, the steady loss in the steady state can be also reduced.

In the switching device 1, at the time of executing the off-control, after the IGBT 11a is turned off, the MOSFET 11b is turned off. Therefore, the current hardly flows to the IGBT 11a, thereby enabling to reduce the switching loss of the IGBT 11a.

In the switching device 1, because the switching loss of the MOSFET 11b to be turned off after the IGBT 11a is small, the switching loss at the time of executing the off-control can be reduced.

In the switching device 1, a large current does not need to be supplied to the IGBT 11a and the MOSFET 11b by executing the switching control of the IGBT 11a and the MOSFET 11b described above. Accordingly, the switching circuit 11 does not need to be constituted by large switching elements in order to cope with a large current, thereby enabling to realize downsizing of the switching device 1.

Furthermore, in the switching device 1, the on-control and the off-control can be executed at a high speed in the entire switching circuit unit 11, and the steady current is supplied at the low VCEsat by using the IGBT 11a and the MOSFET 11b in a steady state. Accordingly, the switching loss and the steady loss can be reduced, and the load can be driven efficiently in all regions from the region where the operation load is small to the region where the operation load is large. Further, because the switching device 1 can drive the load efficiently in all regions from the region where the operation load is small to the region where the operation load is large, energy consumption can be decreased as compared to a conventional configuration. Further, there are effects of extending the product life cycle and, as a result, reducing the environmental loads.

A MOSFET has been explained as the second switching element; however, the second switching element can be an element formed of a wide bandgap semiconductor made of SiC, GaN, or diamond, or an SJMOS (Super Junction Metal-Oxide-Semiconductor).

### Second embodiment.

In the first embodiment, the configuration and the operation of the switching device including the switching circuit in which two switching elements are connected in parallel have been explained. In a second embodiment, a configuration and an operation of a motor drive device 2 including the switching device are explained.

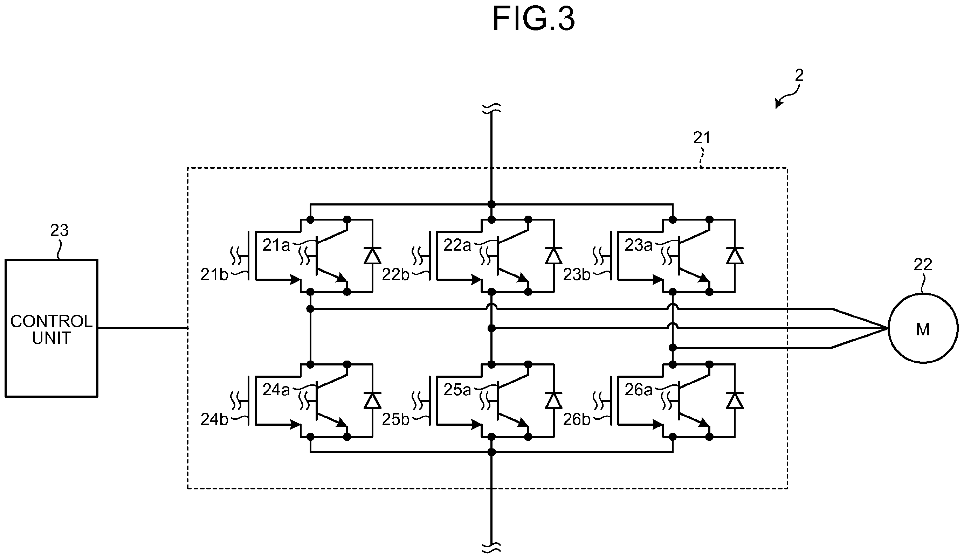

FIG. 3 is a configuration diagram of the motor drive device 2 according to the second embodiment. The motor drive device 2 includes a switching circuit unit 21 constituted by switching elements, a motor unit 22 that converts electric energy to mechanical energy, and a control unit 23 that controls the switching elements.

The switching circuit unit 21 is constituted by connecting in parallel IGBTs 21a, 22a, 23a, 24a, 25a, and 26a as first switching elements and MOSFETs 21b, 22b, 23b, 24b, 25b, and 26b as second switching elements so as to form one switching element group and the switching circuit unit 21 is constituted by connecting a plurality of switching element groups.

The motor unit 22 is driven by the switching circuit unit 21. A three-phase motor is exemplified as the motor unit 22.

The control unit 23 selects one or a plurality of switching element groups from the switching circuit unit 21. When on-control is to be executed, after a second switching element constituting the selected switching element group is turned on, a first switching element is turned on. When off-control is to be executed, after the first switching element constituting the selected switching element group is turned off, the second switching element is turned off.

Detailed configurations of the motor drive device 2 are explained below.

The IGBTs 21a, 22a, 23a, 24a, 25a, and 26a are constituted by switching elements having a low VCEsat and a slower switching speed than that of the MOSFETs 21b, 22b, 23b, 24b, 25b, and 26b.

The MOSFETs 21b, 22b, 23b, 24b, 25b, and 26b are constituted by switching elements having a low VCEsat and a faster switching speed than that of the IGBTs 21a, 22a, 23a, 24a, 25a, and 26a.

The IGBT 21a and the MOSFET 21b, the IGBT 22a and the MOSFET 22b, and the IGBT 23a and the MOSFET 23b are respectively connected in parallel.

Collector terminals of the IGBTs 21a, 22a, and 23a and drain terminals of the MOSFETs 21b, 22b, and 23b are connected to a positive side of a DC power supply (not illustrated), and emitter terminals of the IGBTs 21a, 22a, and 23a and source terminals of the MOSFETs 21b, 22b, and 23b are connected to the motor 22.

The IGBT 24a and the MOSFET 24b, the IGBT 25a and the MOSFET 25b, and the IGBT 26a and the MOSFET 26b are respectively connected in parallel.

Collector terminals of the IGBTs 24a, 25a, and 26a and drain terminals of the MOSFETs 24b, 25b, and 26b are connected to the motor 22, and emitter terminals of the IGBTs 24a, 25a, and 26a and source terminals of the MOSFETs 24b, 25b, and 26b are connected to a negative side of the DC power supply (not illustrated).

The motor drive device 2 executes switching control of switching of the IGBTs 21a, 22a, 23a, 24a, 25a, and 26a and the MOSFETs 21b, 22b, 23b, 24b, 25b, and 26b, according to the on-control and the off-control explained with reference to FIG. 2 in the first embodiment in order to drive the motor 22, and thus a large current does not need to be supplied either to the IGBTs 21a, 22a, 23a, 24a, 25a, and 26a or to the MOSFETs 21b, 22b, 23b, 24b, 25b, and 26b. Accordingly, the switching circuit 21 does not need to be constituted by large switching elements in order to cope with the large current, thereby enabling downsizing thereof.

Furthermore, the motor drive device 2 executes the on-control and the off-control at high speed in the entire switching circuit unit 21, and causes the steady current to flow at the low VCEsat, by using the IGBTs 21a, 22a, 23a, 24a, 25a, and 26a and the MOSFETs 21b, 22b, 23b, 24b, 25b, and 26b in a steady state. Therefore, the motor drive device 2 can reduce the switching loss and the steady loss, and can drive the motor 22 efficiently in all regions from the region where the operation load is small to the region where the operation load is large. Further, because the motor drive device 2 can drive the motor 22 efficiently in the regions from the region where the operation load is small to the region where the operation load is large, the motor drive device 2 can decrease the energy consumption as compared to a conventional configuration, and also has effects of extending the product life cycle and, as a result, reducing the environmental loads.

Further, in a conventional device, a load state or a temperature state has been detected to execute drive control of a motor based on a detection result. In the motor drive device 2, because the same switching operation can be performed in the regions from the region where the operation load is small to the region where the operation load is large, detection of the load state or the temperature state is not required, and the switching loss and the steady loss can be reduced by executing the on-control and the off-control described above.

### Third embodiment.

In the first embodiment, the configuration and the operation of the switching device including the switching circuit in which two switching elements are connected in parallel have been explained. In a third embodiment, a configuration and an operation of a power conversion device 3 including the switching device are explained.

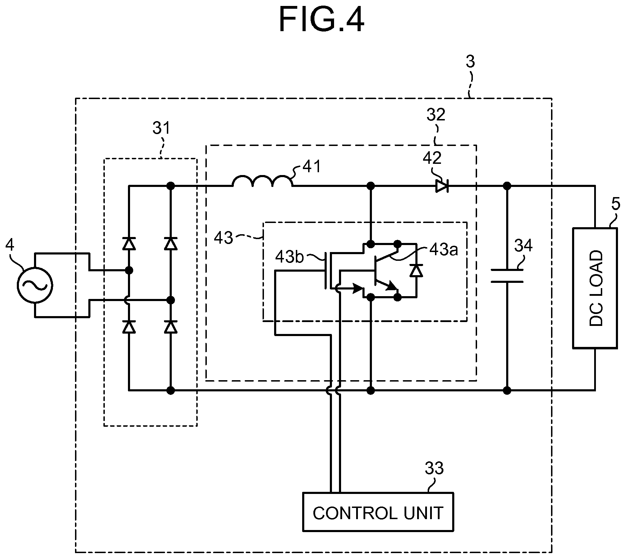

FIG. 4 is a configuration diagram of the power conversion device 3 according to the third embodiment. The power conversion device 3 includes a rectifier circuit unit 31 that rectifies an alternating current output from an AC power supply unit 4 to a direct current, a booster circuit unit 32 that boosts an electric voltage, a control unit 33 that controls the booster circuit unit 32, and a smoothing circuit unit 34 that smooths the boosted voltage. The power conversion device 3 converts an alternating current output from the AC power supply unit 4 to a direct current, and supplies the converted direct current to a DC load 5.

As illustrated in FIG. 4, the rectifier circuit unit 32 is provided in a preceding stage of the switching circuit unit 31. The smoothing circuit unit 34 is provided in a subsequent stage of the switching circuit unit 31.

The booster circuit unit 32 includes a reactor 41, which converts electric energy to magnetic energy, accumulates the magnetic energy, and discharges the accumulated magnetic energy, a diode 42 that prevents backflow of a current, and a switching circuit unit 43 constituted by switching elements.

The reactor 41 is connected to a positive side of the rectifier circuit unit 31. The diode 42 is connected to an output side of the reactor 41. The smoothing circuit unit 34 is connected to a cathode side of the diode 42. The switching circuit unit 43 is connected between a connection point of an output side of the reactor 42 and an anode side of the diode 42 and a negative side of the rectifier circuit unit 31.

The switching circuit unit 43 has the same configuration as that of the switching circuit unit 11 explained in the first embodiment, in which an IGBT 43a as a first switching element that performs switching and a MOSFET 43b as a second switching element that performs switching are connected in parallel.

The IGBT 43a is constituted by a switching element having a low VCEsat and a slower switching speed than that of the MOSFET 43b.

The MOSFET 43b is constituted by an element having a low VCEsat and a faster switching speed than that of the IGBT 43a.

The control unit 33 executes control such that a voltage between both ends of the smoothing circuit unit 34 becomes a set DC voltage, and executes power-factor improvement control by controlling the switching circuit 43 such that the current output from the AC power supply unit 4 has a sine wave of the same phase as that of the voltage output from the AC power supply unit 4.

The control unit 33 executes the power-factor improvement control by executing switching control of the IGBT 43a and the MOSFET 43b according to the on-control and the off-control explained with reference to FIG. 2 in the first embodiment, in order to drive the DC load 5.

The power conversion device 3 does not need to supply a large current to the IGBT 43a and the MOSFET 43b in the power-factor improvement control. Therefore, the switching circuit unit 43 does not need to be constituted by large switching elements in order to cope with the large current, thereby enabling downsizing thereof.

Furthermore, the power conversion device 3 executes the on-control and the off-control at high speed in the entire switching circuit unit 43, and causes the steady current to flow at the low VCEsat, by using the IGBTs 43a and the MOSFETs 43b in a steady state. Therefore, the power conversion device 3 can reduce the switching loss and the steady loss, and can drive the DC load 5 efficiently in all regions from a region where the operation load is small to a region where the operation load is large. Further, because the power conversion device 3 can drive the DC load 5 efficiently in the regions from the region where the operation load is small to the region where the operation load is large, the power conversion device 3 can decrease the energy consumption as compared to the conventional configuration, and also has effects of extending the product life cycle and, as a result, reducing the environmental loads.

Further, in the conventional device, the state of the DC load 5 or the temperature state has been detected to execute power-factor improvement control based on the detection result. In the power conversion device 3, because the same switching operation can be performed in the regions from the region where the operation load is small to the region where the operation load is large, detection of neither the state of the DC load 5 nor the temperature state is required, and the switching loss and the steady loss at the time of the power-factor improvement control can thus be reduced by executing the on-control and the off-control described above.

The configuration of the embodiments described above is only an example of the contents of the present invention. The configuration can be combined with other well-known techniques, and can be modified without departing from the scope of the invention, such as omitting a part of the configuration.

### Reference Signs List

1 switching device, 2 motor drive device, 3 power conversion device, 4 AC power supply unit, 5 DC load, 11, 21, 43 switching circuit unit, 12, 23 control unit, 11a, 21a, 22a, 23a, 24a, 25a, 26a, 43a IGBT, 11b, 21b, 22b, 23b, 24b, 25b, 26b, 43b MOSFET, 22 motor unit, 31 rectifier circuit unit, 32 booster circuit unit, 33 control unit, 34 smoothing circuit unit.

## Claims

1. A switching device comprising:
a switching circuit unit constituted by connecting in parallel a first switching element and a second switching element having a faster switching speed than a switching speed of the first switching element; and
a control unit that turns on the first switching element after turning on the second switching element, at a time of executing on-control, and turns off the second switching element after turning off the first switching element, at a time of executing off-control.

2. The switching device according to claim 1, wherein
the first switching element has a lower collector-emitter saturation voltage than a collector-emitter saturation voltage of the second switching element, and
the second switching element has a smaller switching loss than a switching loss of the first switching element.

3. A motor drive device including the switching device according to claim 1, comprising:
a switching circuit unit, which is constituted by forming one switching element group by connecting the first switching element and the second switching element in parallel and by connecting a plurality of the switching element groups; and
a motor unit driven by the switching circuit unit, wherein
the control unit of the switching device selects one or a plurality of switching element groups out of the switching circuit unit, and at a time of executing on-control, turns on the first switching element after turning on the second switching element, the both switching elements constituting a selected switching element group, and at a time of executing off-control, turns off the second switching element after turning off the first switching element, the both constituting the selected switching element group.

4. A power conversion device including the switching device according to claim 1, comprising:
a rectifier circuit unit provided in a preceding stage of the switching circuit unit of the switching device; and
a smoothing circuit unit provided in a subsequent stage of the switching circuit unit.

5. A switching method of a switching device including a switching circuit unit constituted by connecting in parallel a first switching element and a second switching element having a faster switching speed than a switching speed of the first switching element, the switching method comprising:
at a time of executing on-control,
a first step of turning on the second switching element; and
a second step of turning on the first switching element after the first step, and
at a time of executing off-control,
a third step of turning off the first switching element; and
a fourth step of turning off the second switching element after the third step.
